Europäisches Patentamt

European Patent Office

Office européen des brevets

(11) Publication number: **0 260 308 B1**

## EUROPEAN PATENT SPECIFICATION

(45) Date of publication of patent specification: **02.12.92**   (51) Int. Cl.⁵: **H03M  9/00**

(21) Application number: **87902068.3**

(22) Date of filing: **03.03.87**

(86) International application number:
**PCT/DK87/00023**

(87) International publication number:
**WO 87/05454 (11.09.87 87/20)**

(54) **A METHOD OF MULTIPLEX/DEMULTIPLEX PROCESSING OF INFORMATION AND AN APPARATUS FOR CARRYING OUT THE METHOD.**

(30) Priority: **04.03.86 US 836120**

(43) Date of publication of application:
**23.03.88 Bulletin  88/12**

(45) Publication of the grant of the patent:
**02.12.92 Bulletin  92/49**

(84) Designated Contracting States:
**AT BE CH DE FR GB IT LI LU NL SE**

(56) References cited:
**DE-A- 2 847 778**
**US-A- 3 946 379**
**US-A- 4 377 806**

(73) Proprietor: **BOLT BERANEK AND NEWMAN INC.**
**150 Cambridge Park Drive**
**Cambridge, MA 02140(US)**

(72) Inventor: **BORUP, Gottlob**
**Lejrevej 17**
**DK-3650 Olstykke(DK)**
Inventor: **PEDERSEN, Flemming, Helsted**
**Espegaardsvej 25**
**DK-2880 Bagsvaerd(DK)**

(74) Representative: **WITTRUP, Flemming et al**
**c/o Hofman-Bang & Boutard A/S Adelgade 15**
**DK-1304 Copenhagen K(DK)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

Rank Xerox (UK) Business Services

## Description

The invention concerns a method of multiplex processing of information signals transmitted serially along an energy propagation path. The invention also concerns a data transmission system for implementation of the method.

The known serial to parallel circuits previously used for such a method have been based on the use of shift registers into which serial information are entered stepwise with a certain cycle time, and then the register is sensed in parallel when all the storage cells have been filled. The rate of the serial to parallel conversion is thus restricted partly by the internal time delays of the shift register and partly by the synchronous, cyclic control of the shift register. The said circuit is known from US 3,946,379.

DE 2,847,778 concerns a parallel-to-serial converter which is particularly applicable for optical signals as the above-mentioned shift registers are replaced by semiconductor circuits, e.g. CCD-sensors. As in shift registers, these circuits are unloaded by means of a clock signal, and therefore the speed is vitiated by the same limitations.

The object of the invention is to provide a method of transmitting data serially between a transmitter and a receiver when data are transmitted to the transmitter in parallel form and are again converted to data in parallel form in the receiver, by which method it is possible to obtain a considerably higher data transmission speed than by the prior art methods.

This is achived by the measures defined in Claim 1. By the method according to Claim 1, the flag information signals are propagated in series along with the data information signals and are used for generating a sampling signal which is used for sampling of the energy state on the energy propagation path at respective locations in front of respective sluice circuits.

Preferably, the method is performed by registering the energy state at said locations by respective detector means in response to a detection signal produced from the signal on the energy propagation path and transmitted to the detector means in sequence.

When the method is performed as stated above, the above-mentioned shift registers are completely avoided as the serial information signal propagates along the energy propagation path as a wave signal where the energy states of the waves each represent an information signal. When the energy state is detected on the energy propagation path at predetermined locations and with the above-mentioned dependency upon the detection signal, the serial information signals are transferred to the detector means as information in parallel.

The method provides the effect that mutually identical sections of the first energy propagation path may be used, since the energy propagation conditions for the detection signal and the gate signal, respectively, can be controlled in accordance with this. When the energy propagation paths thus comprise identical sections with respect to propagation conditions, both the demultiplex and the multiplex functions can be optimized to provide the greatest possible working rate.

The above-mentioned advantages are obtained in a quite equivalent manner when the parallel to serial conversion is carried out in that the parallel information signals are represented by energy states which are shortly transferred to predetermined locations along the energy propagation path at points of time representing the time difference between the predetermined mutual time distance between a pair of information signals produced at respective locations on the energy propagation path and the propagation time of the latter signals between the same two locations.

Preferably, the method is performed by transferring the energy states representing the parallel information signals to predetermined locations via respective gate means in response to a gate signal transmitted to the gate means in sequence.

It will be appreciated that the said energy propagation paths may be designed to various forms of energy propagation. The invention will be explained in the detailed part under the assumption of propagation of microwave energy, but it will be appreciated that the invention can be applied equally well to transmission of acoustic energy, optical energy or other energy where the information signals can propagate as a progressive wave along the energy propagation path.

The said detector signals and gate signals do not have to be of the same energy type as the one propagating along the energy propagation paths. In a preferred embodiment, the detector signal and the gate signal are also transmitted as microwave energy, which is preferably transmitted serially to the detector means and the gate means, respectively, in sequence.

As will appear from the foregoing, the invention provides for unprecedented information rates, and it is therefore particularly expedient that the information signals are represented by individual electric oscillations with a frequency spectrum as narrow as possible. When energy propagation paths having uniform energy propagation parameters are used and when the paths are terminated reflectionfree, an optimum transmission rate can be obtained. When information is to be transmitted from one location to another, this usually involves serial transmission between two locations, whereby the parallel to serial conversion according to the invention is used for transmission of the information, while the serial to parallel conversion according to the invention is used for reception of the information.

Finally, the invention concerns a data transmission system comprising means for converting a plurality of information signals transmitted serially along a first energy propagation path into information signals in parallel, and comprising means for converting information signals represented in parallel into information signals capable of propagating serially along a second energy propagation path with said predetermined time distances.

A multiplex apparatus or a transmitter for use in the data transmission system is defined in Claim 7, and a demultiplex apparatus or a receiver is defined in Claim 8.

The data transmission system of the invention also has the previously explained special advantage, viz. the possibility of providing mutually identical energy propagation sections which may be connected via respective directional couplers to a common transmission line. When the demultiplex apparatus and the multiplex apparatus, respectively, are so designed that the detection signal and the gate signal, respectively, are propagated in opposite directions to the directional couplers, precisely the previously explained identity between the energy propagation parameters of the first and the The invention also comprises a demultiplex apparatus and a multiplex apparatus for performing the method explained in the foregoing for demultiplex and multiplex processing, respectively, of information. Such apparatus is defined in claims 12 and 13, and its mode of operation will be readily understood from the above explanation, and also the effect of the features defined in claims 14-16 will be understood from the above explanation. It will be appreciated that the demultiplex apparatus of claim 12 preferably serves as a receiver while the multiplex apparatus of claim 13 serves as a transmitter.

Finally, the invention concerns a data transmission system comprising means for converting a plurality of information signals transmitted serially along a first energy propagation path into information signals in parallel, and comprising means for converting information signals represented in parallel into information signals capable of propagating serially along a second energy propagation path with said predetermined time distances, said transmission system being characterized by the combination of the above-mentioned demultiplex apparatus and multiplex apparatus, the respective energy propagation paths being operatively interconnected.

The data transmission system of the invention also has the previously explained special advantage, viz. the possibility of providing mutually identical energy propagation sections which may be connected via respective directional couplers to a common transmission line. When the demultiplex apparatus and the multiplex apparatus, respectively, are so designed that the detection signal and the gate signal, respectively, are propagated in opposite directions to the directional couplers, precisely the previously explained identity between the energy propagation parameters of the first and the second energy propagation path can be obtained.

The technique described above lends itself particularly well to microwaves, where not only the mentioned energy propagation paths but also feed paths for the detector signals and the gate signals, respectively, can be established by means of microstrip circuits which are very inexpensive to produce. When the invention is used in connection with microstrip circuits, transmission rates of the order of 1 GHz can be obtained by relatively simple components, and transmission rates of the order of 10 GHz can be achieved by means of more advanced microwave components. If optical energy propagation is used, even greater transmission rates can be obtained, which will probably be too expensive with the present technology, but is easily feasible. It is well-known that much work is presently devoted to the development of optical computers, and it will be appreciated that the invention presents a fundamentally new principle to replace shift registers in optical computers.

Preferably, additional gate circuits are provided for transmission of flag signals, which are preferably detected by means of an integrator followed by a pulse generator which is connected to a soft limiting amplifier via the first energy propagation path.

It will readily be understood from the explanation in the foregoing that the preferred embodiment of the data transmission system of the invention may be constructed as microstrip circuits.

The invention will be explained more fully by the following description of some embodiments with reference to the drawing, in which

figs. 1-3 are sketches explaining the principle on which the invention is based,

fig. 4 shows a preferred embodiment of a demultiplex apparatus according to the invention,

fig. 5 shows a preferred embodiment of a multiplex apparatus according to the invention,

fig. 6 shows a preferred embodiment of the data transmission system according to the invention, while

fig. 7 shows a use of the circuit shown in fig. 6.

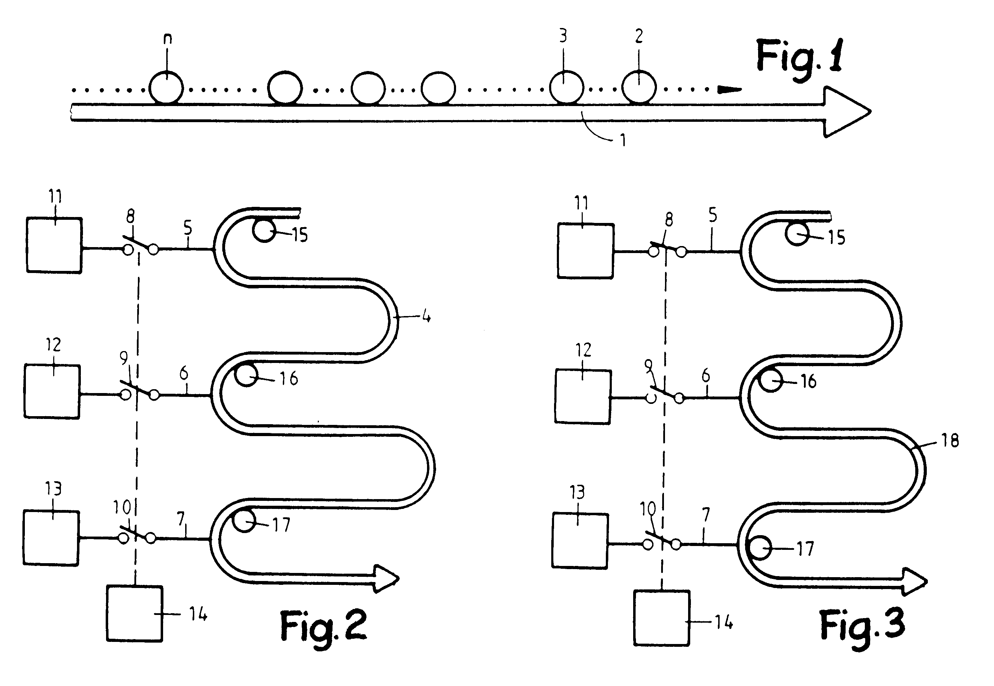

In fig. 1 the numeral 1 designates an energy propagation path along which information-representing energy propagates, symbolically indicated by 2, 3 ... n. In fig. 1 the energy representation occurs with dissimilar, mutual time distances, and, as previously explained, the object of the invention is to provide means both for using such representation from corresponding parallel information and for reproducing the parallel information from serial representation in a manner significantly more rapid than was possible in the past.

Since the parallel-to-serial conversion and the serial-to-parallel-conversion according to the invention act in the same way in principle, only the latter process will be illustrated by means of figs. 2 and 3.

Fig. 2 shows an energy propagation path 4, which has taps 5, 6 and 7 connected to holding circuits 11, 12 and 13, respectively, via switches 8, 9 and 10, respectively. The switches are controlled by a control signal from a circuit 14. The numerals 15, 16 and 17 indicate information energy propagating along the energy propagation path 4, the mutual time distance between the information energy corresponding to the length of the path between the taps 5, 6 and 6, 7. As appears from fig. 2, the information energies 15, 16 and 17 are equidistantly spaced from the taps 5, 6 and 7, respectively, and it will accordingly be appreciated that the information energy can be transferred to the holding circuits 11, 12 and 13, respectively, if the switches 8, 9 and 10 are switched on at the same time precisely when the information energy is present opposite the taps 5, 6 and 7.

Fig. 3 shows almost the same as fig. 2, but with the propagation path 4 replaced by an energy propagation path 18 differing from the energy propagation path shown in fig. 2 in that the lengths of the path, measured between the taps 5, 6 and 6, 7, respectively, are reduced somewhat with respect to the situation in fig. 2. This entails that it will take a little longer for the information energy 15 to arrive at the tap 5 than is the case for the information energy 17 shown in fig. 3 opposite the tap 7. However, it will be appreciated that correct transfer of the information energy to the holding circuits 11, 12 and 13 can be obtained by arranging the propagation delay for the detection signal from the circuit 14 between the switches 10, 9 and 9, 8, respectively, in a manner such that the propagation delay difference precisely compensates for the time shift in the arrival of the information energies at the taps. It will also be appreciated that adaptation of the detection signal delay to the individual switches and of the propagation delay of the information energy between the individual taps may provide conversion of serial information to parallel information applying to any preknown pattern of serial information, i.e. preknown time distances between the individual information signals. A quite similar effect can be obtained by parallel-to-serial conversion, which will appear from the following description of some concrete embodiments.

Microwave circuits will be used by way of example in the description of the concrete embodiments since with the present technology the invention involves incredibly low production costs and very high transmission rates in the order of 1 - 10 GHz.

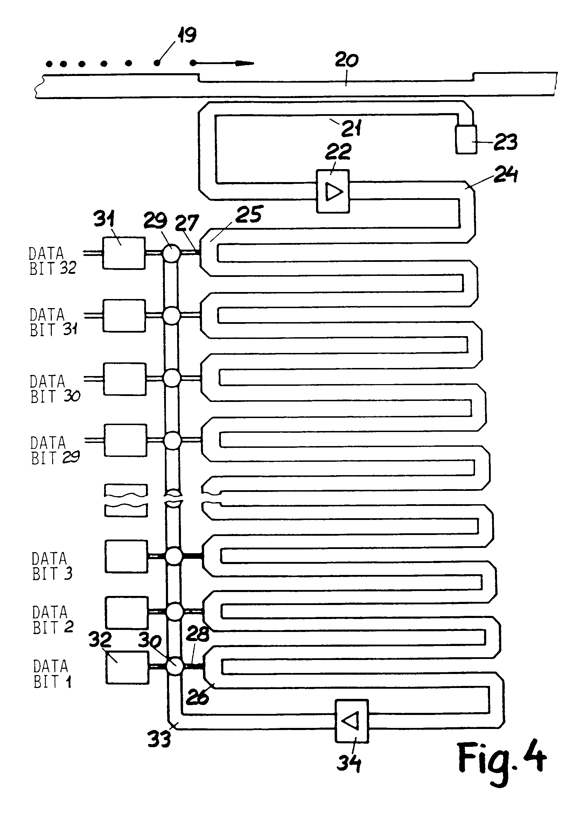

Fig. 4 shows a microwave circuit for serial-to-parallel conversion of serial information symbolized by 19 and propagating in the direction of the arrow along a microwave strip 20. The serial information is transferred via a directional coupler 21 to an amplifier 22, the directional coupler 21 being terminated reflection-free at 23. The output signal of the amplifier 22 is limited so that well-defined signals are transmitted to an energy propagation path 24 consisting of 32 loops, (e.g.) the loops 25 and 26, each, of which has a tap such as 27 and 28, which are connected to holding circuits 31 and 32, respectively, via respective microwave switches 29 and 30. The microwave switches respond to a control pulse propagating on a microwave strip 33 produced by a selective amplifier 34. The amplifier 34 is sensitive to a special information pattern which serves as a flag signal and is transmitted as the first signal in each series of information signals. When the flag signal is detected by the amplifier, a control pulse will propagate along the microstrip 33, and this control pulse arrives first at the microwave switch 30 and eventually at the microwave switch 29. In the embodiment shown there will thus be an increasing time delay for the actuation of the switches as seen from the switch 30 to the switch 29. If it is assumed that the serial information 19 was transmitted with equidistant time distances, expansion would actually happen on reception if the loops 25...26 were of the same length, and if the time delays along the microstrip 33 between the individual micro wave switches 30...29 were the same. Fig. 4 shows the serial information 19 with dissimilar time distances, but it is also shown in fig. 4 that the loop 26 is longer than the loop 25, thereby compensating for the dissimilar time distances in the information signal. Such a combination might also be obtained with loops of the same length by providing dissimilar propagation conditions for the control pulse on the microstrip 33 between the individual microwave switches.

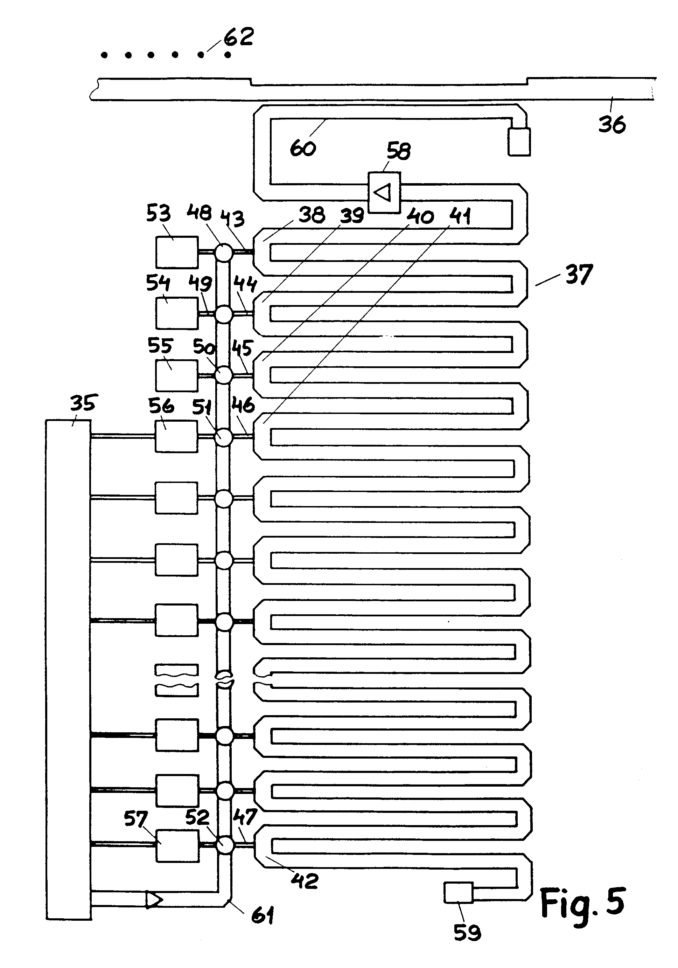

Fig. 5 shows a preferred embodiment of a multiplex apparatus according to the invention, where parallel information from a data processing unit 35 is to be converted into serial information to be transmitted on an energy propagation path 36. The embodiment shown in fig. 5, like the one shown in fig. 4, is designed as a microwave circuit with the energy propagation path being designed as microstrips. More particularly an energy propagation path 37 is provided, consisting of a plurality of micro strip loops, such as the loops 38-42, each of which having a tap 43-47, respectively, connected to holding circuits 53-57, respectively. The holding circuits 53, 54 and 55 contain predetermined information values which are to represent a flag signal in the transmission, said flag signal propagating in front of the data signal proper which originates from the unit 35.

If, for example, it is imagined that the microwave switches 48, 49 and 50 are switched on at a given moment, informationrepresenting charges will simultaneously be transferred to the taps 43, 44 and 45, respectively.

These charges will immediately propagate in opposite directions along the energy propagation path 37, so that, according to the superposition principle, a number of flag signals will be produced, propagating partly in a direction toward an amplifier 58 and partly toward a reflection-free termination 59. The signal is transferred from the amplifier 58 via a directional coupler 60 to the microswitch 36. It will accordingly be appreciated how the parallel information for the unit 35 is converted into serial information, the parallel information being transferred from the unit 35 to the holding circuit 56...57, the unit 35 producing a control pulse on a microstrip 61, propagating to all the microwave switches. Owing to the band width of the amplifier 58 and the inherent filter effect of the microstrip it is desirable to produce uniformpulses, which is preferably provided for in that the microstrip loops 38, 39, 40, 41...42 are of the same length, in that the microstrip lengths between the microwave switches are of the same length. However, owing to the propagation time of the pulse on the microstrip 61 this entails that serial information propagating on the microstrip 36 in the direction of the arrow and represented by 62 will be compressed for a period of time corresponding to the propagation time of the control pulse along the microstrip 61.

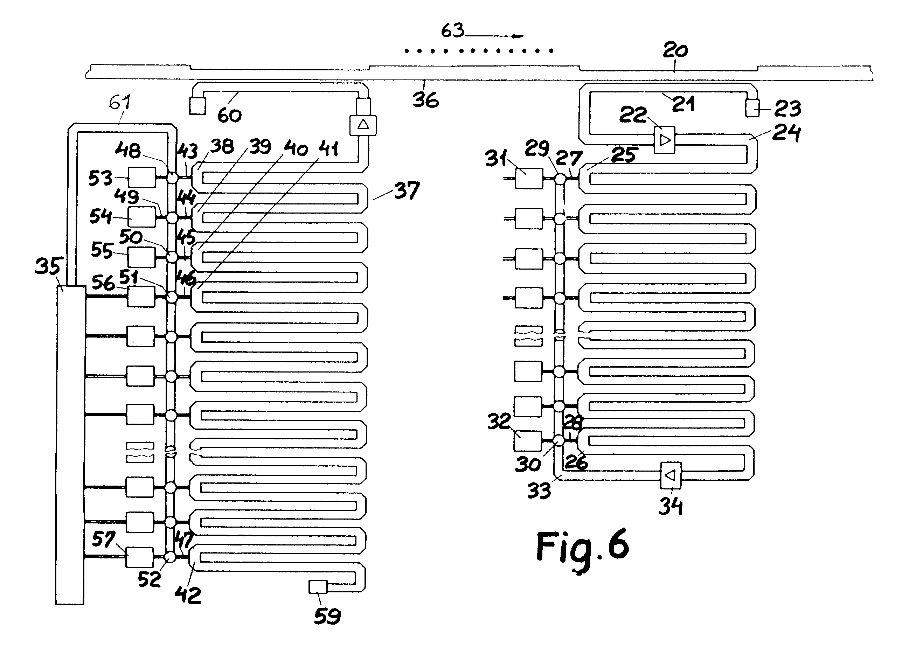

Fig. 6 shows a preferred embodiment of the data transmission system according to the invention, which is in principle a coupling of the circuits shown in figs. 4 and 5. Therefore, the reference numerals used in figs. 4, 5 and 6 are the same, it being stressed that the only, but very essential differences between fig. 6 and the two other figures are that the microstrip 61 is so arranged that the control pulse for the microwave switches propagates in a direction opposite to the one appearing from fig. 5, and that the energy propagation loops 25...26 in the embodiment shown in fig. 6 are shaped in the same way.

Because the microwave switches 48, 49, 50, 51...52 are now actuated in the opposite order, the produced serial information signal 63, which propagates in the direction shown by the arrow in fig. 6, will be somewhat expanded corresponding to the propagation time for the pulse on the microstrip 61. When, as mentioned the loops 25...26 display uniform signal energy propagation time, and this corresponds to the propagation time along the loops 38...42, the information signals 63 will be transferred at the exact moment to the holding circuits 31...32 because of the compression brought about by the fact that the pulse on the microstrip 33 propagates with a certain time delay so that the microwave switch 30 is actuated a little before the microwave switch 29 is actuated.

It will then be appreciated that in the data transmission system according to the invention it is the geometry of the microwave circuits which are decisive for the optimum functioning. It will also be appreciated that this geometry and/or the energy propagation conditions for the pulses on the microstrips 61 and 33 can be changed, so that the data transmission system can also serve as a cryptograph.

As appears from fig. 6, the shown embodiment is designed to convert 32-bit words, which involve a relatively long energy propagation path. Certain transmission systems work with 128-bit words, which would require a very long energy propagation path. However, it is observed that since the invention involves an improvement in the working rate by at least one order by the use of microwave circuits it is sufficient to arrange the circuit according to the invention to for example a 16-bitword and then to combine a plurality of 16-bit words in conventional manner to for example a 128-bit word. When this combination can be handled through the prior art it is possible, by combining said prior art with the invention, to obtain a hybrid circuit which in this example is 16 times faster than the known circuit.

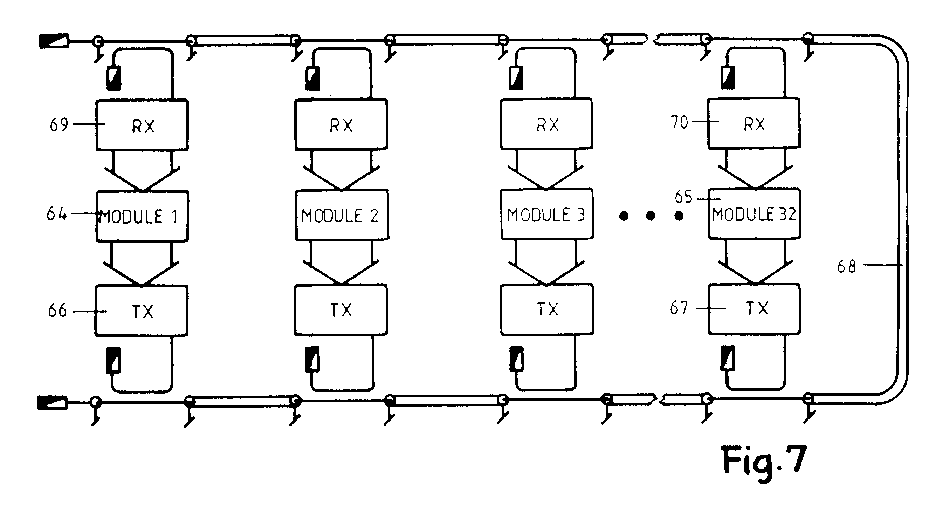

Fig. 7 shows a use of for example the data transmission system shown in fig. 6. Fig. 7 shows a plurality of data processing modules 64...65, each of which comprises a transmitter in the form of a parallel-to-serial converter 66...67 operatively connected to a common transmission line 68, preferably in the form of a co-axial cable, via directional couplers. The cable 68 is also connected to receivers for the data processing modules 64...65 via directional couplers, and these receivers are designed as serial-to-parallel converters 69...70. The configuration shown in fig. 7 is not novel per se, but shows an example of a use in which particularly great advantage can be derived from the quite unsurpassed great parallel-to-serial convertion rate which can be obtained by means of the invention.

For the sake of good order it should also be mentioned that the units 64...65 do not have to transmit/receive all bits in a data word, it being very easy by means of the circuits of the invention to select one or more bits from a data word, which can be provided for by means of the geometry of the energy propagation path and the propagation delay of the detection pulses.

## Claims

1. A method of information multiplex processing, comprising

conversion of binary information signals represented in parallel into information signals propagating serially along a first energy propagation path (37) with predetermined mutual time distances, said first energy propagation path (37) being operatively interconnected to a second energy propagation path (24),

conversion of the plurality of information signals transmitted serially along the second energy propagation path (24) with predetermined mutual distances into information signals in parallel, corresponding to the binary information signals represented in parallel,

whereby electric energy is transferred via sequentially actuated switches (48...52) to predetermined locations (38-42) along the first energy propagation path (37) at points of time representing the time difference between a pair of successive serial information signals on the first energy propagation path (37), and

whereby the energy state at a plurality of predetermined locations (25-26) along the second energy propagation path (24) is registered at points of time representing the difference between the arrival times of a pair of information signals at a pair of adjacent locations (25-26) along the second energy propagation path (24),

**characterized in**

that the number of locations (38-42) on the first energy propagation path (37) is larger than the number of locations (25-26) on the second energy propagation path (24),

that at least some of the excess locations (38-40) on the first energy propagation path (37) are used for transmitting flag information signals serially with the information signals, and

that the flag information signals are detected at the second energy propagation path (24) and used for producing a detection signal which is transmitted at a propagation rate corresponding to the delay between successively actuated switches (48...52) to gate means (29-30) connected to the plurality of locations (25, 26) along the second energy propagation path (24).

2. A method according to claim 1, **characterized** in that the information signals are substantially represented by a single electric oscillation with a narrow frequency spectrum.

3. A data transmission system comprising:

means (43-52) for conversion of binary information signals represented in parallel into information signals capable of propagating serially along a first energy propagation path (37) with predetermined mutual time distances, said first energy propagation path (37) being operatively interconnected to a second energy propagation path (24),

means (27-30) for conversion the plurality of information signals transmitted serially along the second energy propagation path (24) with predetermined mutual time distances into information signals in parallel, correspnding to the binary information signals represented in paralell,

a plurality of coupling points (35-42) along the first energy propagation path (37), each of said coupling points (38-42) being designed to receive an energy amount defining an information signal represented in parallel, via a respective gate circuit (48-52) in response to gate signals,

means designed to produce and transmit the gate signals so that said energy amounts are transferred via sequentially actuated switches (48...52) to respective coupling points at points of time representing the time difference between the predetermined mutual time distance between a pair of successive information signals,

a plurality of signal taps along the second energy propagation path, each of said signal taps being connected to a respective detector circuit,

means for producing and transmitting a detection signal for the detection means so that the energy state at the signal taps is registered at points of time representing the difference between the arrival of a pair of information signals at a pair of adjacent signal taps along the second energy propagation path (24),

**characterized in**

that the number of locations (38-42) on the first energy propagation path (37) is larger than the number of locations (25-26) on the second energy propagation path (24),

that at least some of the excess locations (38-42) on the first energy propagation path (37) are used for transmitting of flag information signals serially with the information signals, and

that a circuit being provided in connection with the second energy propagation path (24) to detect the flag information signals at the second energy propagation path (24) and to produce, in response thereto, said detection signal for the detector means.

4. A system according to claim 3, **characterized** in that part of the first energy propagation path (37) and part of the second energy propagation path (24) comprise geometrically identical microstrip circuits, and that the first energy propagation path (37) moreover comprises microstrip circuits for transmission of flag information signals serially with the data signals, the second energy propagation path (24) comprising a limiting amplifier (34) and a trigger circuit disposed at their respective sides of said part of the second energy propagation path (24).

5. A system according to claim 3 or 4, **characterized** in that the microstrip circuits are designed to support electromagnetic signals with a relatively narrow frequency spectrum.

6. A system according to any of the claims 3 to 5, **characterized** by a transmission bus common to a plurality of energy propagation paths, all associated first energy propagation paths (37) being coupled to the bus via uniformly oriented first directional couplers (60), all associated second energy propagation paths (24) being coupled to the bus via second directional couplers (21) oppositely oriented with respect to the first directional couplers.

7. A system according to any of the claims 3 to 6, **characterized** in that one end (59) of the first energy propagation path (37) is terminated reflection-free, the other end of the path being coupled to a microwave transmission line (36) which portion of the system belongs to a transmitter circuit.

8. A system according to any of the claims 3 to 7, **characterized** in that one end of the second energy propagation path (24) is coupled to a microwave transmission line (36), the other end of the signal propagation path being coupled to trigger circuits (33, 34) which portion of the system belongs to a receiver circuit.

9. A system according to claim 8, **characterized** in that said taps (27-28) are each connected to one input of an associated gate circuit (29-30), and that the other input of said gate circuits is connected to taps along an internal transmission line whose input end is connected to the output of said trigger circuit (33, 34).

10. A system according to claim 8, **characterized** in that the second energy propagation path (24) is connected to the microwave transmission line (36) via a limiting amplifier (22).

**Patentansprüche**

1. Verfahren zum Informations-Multiplexverarbeiten, das umfaßt;

ein Umwandeln binärer Informationssignale, die parallel dargestellt sind, in Informationssignale, die sich seriell entlang eines ersten Energieausbreitungspfades (37) ausbreiten, und zwar mit vorbestimmten gegenseitigen Zeitabständen, wobei der erste Energieausbreitungspfad (37) betriebsmäßig mit einem zweiten Energieausbreitungspfad (24) verbunden ist,

eine Umwandlung der Vielzahl von Informationssignalen, die seriell entlang dem zweiten Energieausbreitungspfad (24) übertragen werden, und zwar mit vorbestimmten gegenseitigen Abständen, in parallele Informationssignale, die den binären Informationssignalen entsprechen, die parallel dargestellt sind,

wobei elektrische Energie über aufeinanderfolgend betätigte Schalter (48...52) zu vorbestimmten Orten (38-42) entlang des ersten Energieausbreitungspfads (37) zu Zeitpunkten übertragen wird, die die Zeitdifferenz zwischen einem Paar aufeinanderfolgender serieller Informationssignale auf dem ersten Energieausbreitungspfad (37) darstellen, und

wobei der Energiezustand bei einer Vielzahl vorbestimmter Orte (25-26) entlang des zweiten Energieausbreitungspfades (24) bei Zeitpunkten registriert wird, die die Differenz zwischen den Ankunftszeiten eines Paars von Informationssignalen bei einem Paar von benachbarten Orten (25-26) entlang des zweiten Energieausbreitungspfades (24) darstellen,

**dadurch gekennzeichnet,**

daß die Anzahl von Orten (38-42) auf dem ersten Energieausbreitungspfad (37) größer ist als die Anzahl von Orten (25-26) auf dem zweiten Energieausbreitungspfad (24),

daß mindestens einige der zusätzlichen Orte (38-40) auf dem ersten Energieausbreitungspfad (37) zum Übertragen von Flag-Informationssignalen seriell mit den Informationssignalen benutzt werden, und

daß die Flag-Informationssignale bei dem zweiten Energieausbreitungspfad (24) detektiert werden und zum Erzeugen eines Detektionssignals benutzt werden, das bei einer Ausbreitungsrate übertragen wird, die der Verzögerung zwischen aufeinanderfolgend betätigten Schaltern (48...52) zu Gate-Einrichtungen (29-30) entspricht, die mit der Vielzahl von Orten (25, 26) entlang des zweiten Energieausbreitungspfades(24) verbunden sind.

2. Verfahren nach Anspruch 1, dadurch gekennzeichnet, daß die Informationssignale im wesentlichen durch eine einzige elektrische Oszillation mit einem engen Frequenzspektrum dargestellt werden.

3. Datenübertragungssystem, das umfaßt:

Einrichtungen (43-52) zum Umwandeln von binären Informationssignalen, die parallel dargestellt sind, in Informationssignale, die sich seriell entlang eines ersten Energieausbreitungspfades (37) mit vor-bestimmten gegenseitigen Zeitabständen ausbreiten können, wobei der erste Energieausbreitungspfad (37) betriebsmäßig mit einem zweiten Energieausbreitungspfad (24) verbunden ist,

Einrichtungen (27-30) zur Umwandlung der Vielzahl von Informationssignalen, die seriell entlang des zweiten Energieausbreitungspfades (24) mit vorbestimmten gegenseitigen Zeitabständen übertragen werden, in parallele Informationssignale, die den binären Informationssignalen entsprechen, die parallel dargestellt sind,

eine Vielzahl von Kupplungspunkten (35-42) entlang des ersten Energieausbreitungspfades (37), wobei jeder der Kupplungspunkte (38-42) aufgebaut ist, um einen Energiebetrag zu empfangen, der ein Informationssignal definiert, das parallel dargestellt ist, und zwar über einen jeweiligen Gate-Schaltkreis (48-52) in Antwort auf Gate-Signale,

eine Einrichtung, die aufgebaut ist, um die Gate-Signale zu erzeugen und zu übertragen, so daß die Energiebeträge über aufeinanderfolgend betätigte Schalter (48...52) zu jeweiligen Kupplungspunkten zu Zeitpunkten übertragen werden, die die Zeitdifferenz zwischen dem vorbestimmten gegenseitigen Zeitabstand zwischen einem Paar aufeinanderfolgender Informationssignale darstellen,

eine Vielzahl von Signal-Abgriffstellen entlang des zweiten Energieausbreitungspfades, wobei jede der Signal-Abgriffstellen mit einem jeweiligen Detektor-Schaltkreis verbunden ist,

eine Einrichtung zum Erzeugen und Übertragen eines Detektionssignals für die Detektionseinrichtung, so daß der Energiezustand bei den Signal-Abgriffstellen zu Zeitpunkten registriert wird, die die Differenz zwischen der Ankunft eines Paars von Informationssignalen bei einem Paar benachbarter Signal-Abgriffstellen entlang des zweiten Energieausbreitungspfades (24) darstellen,

**dadurch gekennzeichnet,**

daß die Anzahl von Orten (38-42) auf dem ersten Energieausbreitungspfad (37) größer ist als die Anzahl von Orten (25-26) auf dem zweiten Energieausbreitungspfad (24),

daß mindestens einige der überzähligen Orte (38-42) auf dem ersten Energieausbreitungspfad (37) zum Übertragen von Flag-Informationssignalen seriell mit den Informationssignalen benutzt werden, und

daß ein Schaltkreis in Verbindung mit dem zweiten Energieausbreitungspfad (24) vorgesehen ist, um die Flag-Informationssignale bei dem zweiten Energieausbreitungspfad (24) zu detektieren, und um in Antwort darauf das Detektionssignal für die Detektoreinrichtung zu erzeugen.

4. System nach Anspruch 3, dadurch gekennzeichnet, daß ein Teil des ersten Energieausbreitungspfades (37) und ein Teil des zweiten Energieausbreitungspfades (24) geometrisch identische Mikrostreifenleiter-Schaltkreise umfaßt, und daß der erste Energieausbreitungspfad (37) darüber hinaus Mikrostreifenleiter-Schaltkreise zum Übertragen von Flag-Informationssignalen seriell mit den Datensignalen umfaßt, wobei der zweite Energieausbreitungspfad (24) einen Begrenzungsver-stärker (34) und einen Trigger-Schaltkreis umfaßt, die an den jeweiligen Seiten des Teils des zweiten Energieausbreitungspfades (24) angeordnet sind.

5. System nach Anspruch 3 oder 4, dadurch gekennzeichnet, daß die Mikrostreifenleiter-Schaltkreise aufgebaut sind, um elektromagnetische Signale mit einem relativ engen Frequenzspektrum zu unterstützen.

6. System nach einem der Ansprüche 3 bis 5, gekennzeichnet durch einen Übertragungsbus, der einer Vielzahl von Energieausbreitungspfaden gemeinsam ist, wobei alle zugeordneten ersten Energieausbreitungspfade (37) mit dem Bus über einheitlich ausgerichtete erste Richtkoppler (60) gekoppelt sind, und alle zugeordneten zweiten Energieausbreitungspfade (24) mit dem Bus über zweite Richtkoppler (21) gekoppelt sind, die entgegengesetzt in bezug auf die ersten Richtkoppler ausgerichtet sind.

7. System nach einem der Ansprüche 3 bis 6, dadurch gekennzeichnet, daß ein Ende (59) des ersten Energieausbreitungspfades (37) reflexionsfrei abgeschlossen ist und das andere Ende des Pfades mit einer Mikrowellenübertragungsleitung (36) gekoppelt ist, wobei der Teil des Systems zu einem Sendeschaltkreis gehört.

8. System nach einem der Ansprüche 3 bis 7, dadurch gekennzeichnet, daß ein Ende des zweiten Energieausbreitungspfades (24) mit einer Mikrowellenübertragungsleitung (36) gekoppelt ist und das andere Ende des Signalausbreitungspfades mit Trigger-Schaltkreisen (33, 34) gekoppelt ist, wobei der Teil des Systems zu einem Empfänger-Schaltkreis gehört.

9. System nach Anspruch 8, dadurch gekennzeichnet, daß die Abgriffsstellen (27-28) jeweils mit einem Eingang eines zugehörigen Gate-Schaltkreises (29-30) verbunden sind, und daß der andere Eingang der Gate-Schaltkreise mit Abgriffsstellen entlang einer internen Übertragungsleitung verbunden ist, dessen Eingangsende mit dem Ausgang des Trigger-Schaltkreises (33, 34) verbunden ist.

10. System nach Anspruch 8, dadurch gekennzeichnet, daß der zweite Energieausbreitungspfad (24) mit der Mikrowellenübertragungsleitung (36) über einen begrenzenden Verstärker (22) verbunden ist

**Revendications**

1. Procédé de traitement multiplex d'informations comprenant :

une conversion de signaux d'information binaires représentés en parallèle dans des signaux d'information se propageant en série le long d'une première trajectoire de propagation d'énergie (37) avec des distances de temps mutuelles prédéterminées, ladite première trajectoire de propagation d'énergie (37) étant interconnectée, de façon opérationnelle, à une seconde trajectoire de propagation d'énergie (24),

une conversion de la pluralité des signaux d'information transmis en série le long de la seconde trajectoire de propagation d'énergie (24) avec des distances mutuelles prédéterminées dans des signaux d'information en parallèle, correspondants aux signaux d'information binaires représentés en parallèle,

dans lequel de l'énergie électrique est transféré, par l'intermédiaire de commutateurs actionnés de façon séquentielle (48...52) à des emplacements prédéterminés (38-42) le long de la première trajectoire de propagation d'énergie (37) en des points de temps représentant la différence de temps entre une paire de signaux successifs d'information en série sur la première trajectoire de propagation d'énergie (37), et ;

dans lequel l'état d'énergie a une pluralité d'emplacements prédéterminés (25-26) le long de la seconde trajectoire de propagation d'énergie (24) est enregistré en des points de temps représentant la différence entre les temps d'arrivée d'une paire de signaux d'information, à une paire d'emplacements adjacents (25-26) le long de la seconde trajectoire de propagation d'énergie (24),

caractérisé en ce que

le nombre d'emplacements (38-42) sur la première trajectoire de propagation d'énergie (37) est plus important que le nombre d'emplacements (25-26) sur la seconde trajectoire de propagation d'énergie (24),

au moins quelques uns des emplacements en excès (38-40) sur la première trajectoire de propagation d'énergie (37) sont utilisés pour transmettre des signaux d'information de signalisation en série avec les signaux d'information, et,

les signaux d'information de signalisation sont détectés sur la seconde trajectoire de propagation d'énergie (24) et sont utilisés pour produire un signal de détection qui est transmis à une vitesse de propagation correspondant au retard entre des commutateurs actionnés successivement (48...52) vers des moyens de grille (29-30) connectés à la pluralité d'emplacements (25, 26) le long de la seconde trajectoire de propagation d'énergie (24).

**2.** Procédé selon la revendication 1 caractérisé en ce que les signaux d'information sont représentés essentiellement par une oscillation électrique unique ayant un spectre de fréquences étroit.

**3.** Système de transmission de données comprenant :

des moyens (43-52) pour transformer des signaux d'information binaires représentés en parallèle en signaux d'information capables de se propager en série le long d'une première trajectoire de propagation d'énergie (37) avec des distances de temps mutuelles prédéterminées, ladite première trajectoire de propagation d'énergie (37) étant interconnectée de façon opérationnelle à une seconde trajectoire de propagation d'énergie (24),

des moyens (27-30) pour transformer la pluralité de signaux d'information transmis en série le long de la seconde trajectoire de propagation d'énergie (24) avec des distances de temps mutuelles prédéterminées, en signaux d'information en parallèle correspondants aux signaux d'information binaires représentés en parallèle,

une pluralité de points de couplage (35-42) le long de la première trajectoire de propagation d'énergie (37), chacun desdits points de couplage (38-42) étant conçu de façon a recevoir une quantité d'énergie définissant un signal d'information représenté en parallèle, par l'intermédiaire d'un circuit de grille respectif (48-52), en réponse aux signaux de grille,

des moyens conçus de façon à produire et à transmettre les signaux de grille de manière que lesdites quantités d'énergie soient transférées, par l'intermédiaire de commutateurs actionnés séquentiellement (48...52), à des points de couplage respectifs, en des points de temps représentant la différence de temps entre la distance de temps mutuelle prédéterminée entre une paire de signaux d'information successifs,

une pluralité de prises de signaux le long d'une seconde trajectoire de propagation d'énergie chacune desdites prises de signaux étant connectée à un circuit détecteur respectif,

des moyens pour produire et transmettre un signal de détection pour les moyens de détection de manière que l'état d'énergie aux prises de signaux soit enregistré en des points de temps représentant la différence entre l'arrivée d'une paire de signaux d'information à une paire de prises de signaux adjacentes le long de la seconde trajectoire de propagation d'énergie (24),

caractérisé en ce que

le nombre d'emplacements (38-42) sur la première trajectoire de propagation d'énergie (37) est plus important que le nombre d'emplacements (25-26) sur la seconde trajectoire de propagation d'énergie (24),

au moins certains des emplacements en excès (38-42) sur la première trajectoire de propagation d'énergie (37) sont utilisés pour transmettre des signaux d'information de signalisation, en série avec les signaux d'information et,

on prévoit un circuit en liaision avec la seconde trajectoire de propagation d'énergie (24) pour détecter les signaux d'information de signalisation sur la seconde trajectoire de propagation d'énergie (24) et pour produire, en réponse à cette détection, ledit signal de détection pour les moyens détecteurs.

**4.** Système selon la revendication 3 caractérisé en ce que une partie de la première trajectoire de propagation d'énergie (37) et une partie de la seconde trajectoire de propagation d'énergie (24) comprennent des circuits microbandes géométriquement identiques et en ce que la première trajectoire de propagation d'énergie (37) comprend en outre des circuits microbandes pour la transmission de signaux d'information de signalisation en série avec les signaux de données, la seconde trajectoire de propagation d'énergie (24) comprenant un amplificateur de limitation (34) et un circuit de déclenchement disposés sur leurs côtés respectifs de ladite partie de la seconde trajectoire de propagation d'énergie (24).

5. Système selon la revendication 3 ou 4 caractérisé en ce que les circuits microbandes sont conçus de façon à supporter des signaux électromagnétiques ayant un spectre de fréquences relativement étroit.

6. Système selon l'une quelconque des revendications 3 à 5 caractérisé par un bus de transmission commun à une pluralité de trajectoires de propagation d'énergie, toutes les premières trajectoires associées de propagation d'énergie (37) étant couplées au bus par l'intermédiaire de premiers coupleurs directionnels (60) uniformément orientés, toutes les secondes trajectoires de propagation d'énergie associées (24) étant coupleés au bus par l'intermédiaire de seconds coupleurs directionnels (21), orientés de façon opposée par rapport auxdits premiers coupleurs directionnels.

7. Système selon l'une quelconque des revendications 3 à 6 caractérisé en ce qu'une extrémité (59) de la première trajectoire de propagation d'énergie (37) se termine en étant exempte de réflexion, l'autre extrémité de la trajectoire étant couplé à une ligne de transmission micro-onde (36), cette portion du système appartenant à un circuit émetteur.

8. Système selon l'une quelconque des revendications 3 à 7 caractérisé en ce qu'une extrémité de la seconde trajectoire de propagation d'énergie (24) est couplée à une ligne de transmission micro-onde (36), l'autre extrémité de la trajectoire de propagation de signaux étant couplé à des circuits de déclenchement (33,34), cette portion du système appartenant à un circuit récepteur.

9. Système selon la revendication 8 caractérisé en ce que lesdites prises (27-28) sont chacune connectées à une entrée d'un circuit de grille associé (29-30) et en ce que l'autre entrée dudit circuit de grille est connectée à des prises le long d'une ligne de transmission interne dont l'extrémité d'entrée est connectée à la sortie dudit circuit de déclenchement (33,34).

10. Système selon la revendication 8 caractérisé en ce que la seconde trajectoire de propagation d'énergie (24) est connecté à une ligne de transmission micro-onde (36) par l'intermédiaire d un amplificateur limiteur (22).

Fig.1

Fig.2

Fig.3

Fig. 4

Fig. 5

Fig.6

Fig.7